# EUROPEAN PATENT SPECIFICATION

(11) **EP 4 546 763 B1**
(45) Date of publication and mention of the grant of the patent: **29.04.2026**
(21) Application number: 23846872.2
(22) Date of filing: 10.07.2023
(51) Int. Cl.: H04M 1/23, H04M 1/02, H05K 5/06, H05K 5/00, G06V 40/12, H04M 1/18

(54) **ELECTRONIC DEVICE INCLUDING KEY ASSEMBLY**
ELEKTRONISCHE VORRICHTUNG MIT SCHLÜSSELANORDNUNG
DISPOSITIF ÉLECTRONIQUE COMPRENANT UN ENSEMBLE DE TOUCHES

(30) Priority: 27.07.2022 KR 20220093174; 30.09.2022 KR 20220125471
(43) Date of publication of application: 30.04.2025
(73) Proprietor: Samsung Electronics Co., Ltd., Suwon-si, Gyeonggi-do 16677 (KR)
(72) Inventor: SONG, Dongchul, Suwon-si Gyeonggi-do 16677 (KR); AHN, Byungwoo, Suwon-si Gyeonggi-do 16677 (KR); HEO, Kyungman, Suwon-si Gyeonggi-do 16677 (KR); KANG, Taehwan, Suwon-si Gyeonggi-do 16677 (KR)
(74) Representative: Gulde & Partner
(86) International application number: PCT/KR2023/009776
(87) International publication number: WO 2024/025213

(56) References cited:
- KR-A- 20160 051 880
- KR-A- 20170 087 684
- KR-A- 20170 098 028
- KR-A- 20180 024 627
- US-A1- 2019 037 060

## Description

### [Technical Field]

An embodiment of the disclosure relates to an electronic device including a key assembly.

### [Background Art]

With the development of electronic, information, and communication technologies, various functions are being integrated into a single electronic device. For example, a smartphone includes not only a communication function but also functions such as functions of an audio playback device, an imaging device, or an electronic organizer, and more various functions may be realized on the smartphone through the installation of additional applications. An electronic device may not only execute installed applications or stored files but also connect to a server or another electronic device in a wired or wireless manner to receive a variety of information in real time.

As it has become more common for a user to carry and use an electronic device on the go, the electronic device may be exposed to various environments. For example, as the user's living space changes, the electronic device may be exposed to harsh conditions such as high humidity or air pollution. High humidity or polluted air may cause contamination or corrosion of various electronic components or wiring in the inner space of the electronic device. KR 2017 0098028 A discloses an electronic device comprising: an electronic device housing having a through-hole formed therein; a key exposed through the through-hole and capable of being pressed; a key switch disposed on a rear surface of the key and configured to enable the key to be pressed and to detect the pressing of the key; a structure provided on a lower portion of the electronic device housing and configured to bear the pressing of the key while facing the key switch; and a dummy detachably provided between the housing and the structure, wherein the dummy, when being attached, may support the key and the key switch such that the key and the key switch are capable of being pressed in the through-hole.

### [Detailed Description of the Invention]

### [Technical Solution]

The invention is directed to the subject-matter of the independent claim. Advantageous embodiments are set out in the dependent claims.

An electronic device according to various embodiments of the disclosure includes: a housing including an opening formed on one surface; and a key assembly formed to be at least partially exposed through the opening, wherein the key assembly includes: a first plate; a second plate disposed on the first plate, the second plate including a first hole formed at a position corresponding to the opening, and a second hole spaced apart from the first hole; a key disposed between the first plate and the second plate and having at least a portion passing through the first hole; a printed circuit board electrically connected to the key and having at least a portion disposed at a position corresponding to the second hole; a sealing member disposed between the first plate and the second plate, and including a third hole corresponding to the first hole and a fourth hole corresponding to the second hole; and a bonding member applied inside the second hole to bond a portion of the printed circuit board to the second plate.

### [Brief Description of Drawings]

FIG. 1 is a block diagram of an electronic device in a network environment according to an embodiment of the disclosure.
FIG. 2 is a front perspective view of an electronic device according to various embodiments of the disclosure.
FIG. 3 is a rear perspective view of the rear surface of an electronic device according to various embodiments of the disclosure.
FIG. 4 is an exploded perspective view of an electronic device, according to various embodiments of the disclosure.
FIG. 5 illustrates one surface of an electronic device having a key assembly disposed therein according to various embodiments of the disclosure.
FIG. 6 is a perspective view of a key assembly according to an embodiment of the disclosure.
FIGS. 7A and 7B are exploded perspective views of a key assembly according to an embodiment of the disclosure.
FIG. 8 is a perspective view of a withdrawal portion of a printed circuit board, as seen from the top surface.
FIG. 9 is a front view of a withdrawal portion of a printed circuit board, as seen from above.
FIG. 10 is a cross-sectional view of the withdrawal portion of the printed circuit board in FIG. 9, taken along line B-B'.
FIG. 11 is a cross-sectional view of the withdrawal portion of the printed circuit board in FIG. 9, taken along line A-A'.
FIG. 12 is a perspective view of a key assembly according an embodiment of the disclosure.
FIGS. 13A and 13B are exploded perspective views of a key assembly according to an embodiment of the disclosure.
FIG. 14 is a cross-sectional view of the withdrawal portion of the printed circuit board in FIG. 9, taken along line C-C'.
FIG. 15 is a cross-sectional view of the withdrawal portion of the printed circuit board in FIG. 9, taken along line B-B'.

### [Mode for Carrying out the Invention]

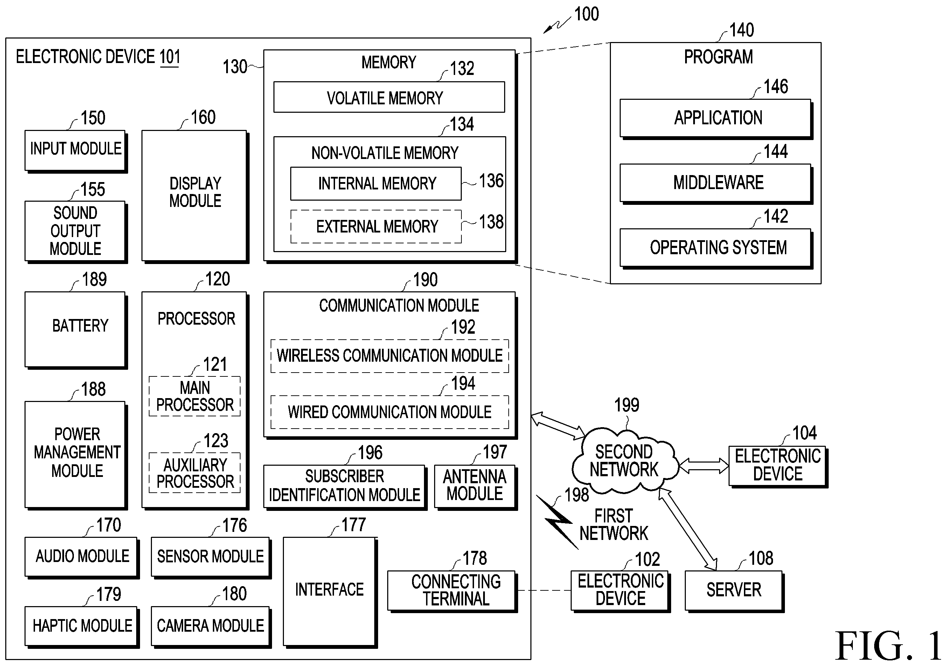

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program) including one or more instructions that are stored in a storage medium (e.g., internal memory or external memory) that is readable by a machine (e.g., the electronic device). For example, a processor (e.g., the processor) of the machine (e.g., the electronic device) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

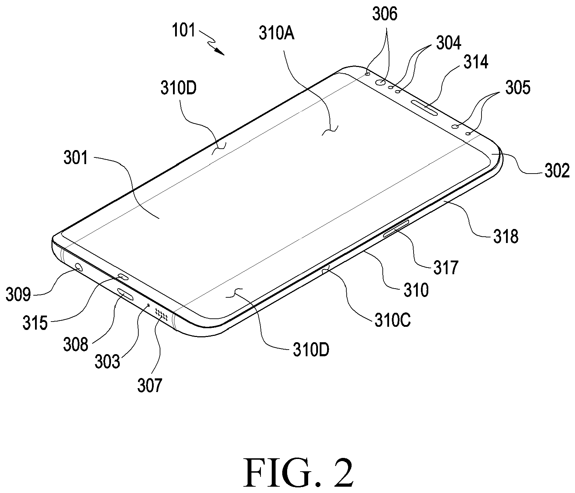

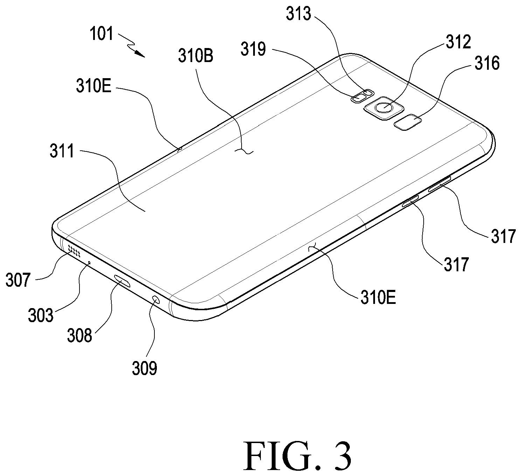

FIG. 2 is a front perspective view of an electronic device according to an embodiment of the disclosure. FIG. 3 is a rear perspective view of an electronic device according to an embodiment of the disclosure.

Referring to FIGS. 2 and 3, an electronic device 101 according to an embodiment may include a housing 310 which includes a first surface (or a front surface) 310A, a second surface (or a rear surface) 310B, and a side surface 310C surrounding a space between the first surface 310A and the second surface 310B. In another embodiment (not shown), the housing 310 may refer to a structure that forms some of the first surface 310A, the second surface 310B, and the side surface 310C in FIG. 2. According to an embodiment, the first surface 310A may be formed by a front plate 302 which is at least partially substantially transparent (e.g., a polymer plate or a glass plate including various coating layers). The second surface 310B may be formed by a rear plate 311 which is substantially opaque. The rear plate 311 may be formed by, for example, coated or tinted glass, ceramic, polymer, metal (e.g., aluminum, stainless steel (STS), or magnesium), or a combination of at least two of the above materials. The side surface 310C may be coupled to the front plate 302 and the rear plate 311, and may be formed by a lateral bezel structure (or "lateral member") 318 including metal and/or polymer. In an embodiment, the rear plate 311 and the lateral bezel structure 318 may be integrally formed and include the same material (e.g., a metal material such as aluminum).

In the illustrated embodiment, the front plate 302 may include two first regions 310D which are formed on both long edge ends of the front plate 302 and are curved and seamlessly extending from the first surface 310A toward the rear plate 311. In the illustrated embodiment (see FIG. 3), the rear plate 311 may include two second regions 310E which are formed at both long edge ends and are curved and seamlessly extending from the second surface 310B toward the front plate 302. In an embodiment, the front plate 302 (or the rear plate 311) may include only one of the first regions 310D (or the second regions 310E). In another embodiment, some of the first regions 310D or the second regions 310E may not be included. In the above embodiments, when viewed from a side surface of the electronic device 101, the lateral bezel structure 318 may have a first thickness (or width) on a side surface that does not include the first regions 310D or the second regions 310E, and a second thickness, which is thinner than the first thickness, on a side surface that includes the first regions 310D or the second regions 310E.

According to an embodiment, the electronic device 101 may include at least one of a display 301, audio modules 303, 307, and 314, sensor modules 304, 316, and 319, camera modules 305, 312, and 313, key input devices 315 and 317, a light-emitting element 306, and connector holes 308 and 309. In an embodiment, the electronic device 101 may omit at least one of the components (e.g., the light-emitting element 306) or may additionally include other components.

According to an embodiment, the display 301 may be visually exposed, for example, through a considerable portion of the front plate 302. In an embodiment, at least a portion of the display 301 may be exposed through the front plate 302 forming the first surface 310A and the first regions 310D of the side surface 310C. In an embodiment, the corner of the display 301 may be formed in a shape substantially identical to the adjacent outer shape of the front plate 302. In another embodiment (not shown), to expand the area of the display 301 exposed, the gap between the outer periphery of the display 301 and the outer periphery of the front plate 302 may be formed to be substantially the same.

According to an embodiment, the surface (or the front plate 302) of the housing 310 may include a screen display region that is formed as the display 301 is visually exposed. In one example, the screen display region may include the first surface 310A and the first regions 310D.

In another embodiment (not shown), recesses or openings may be formed in a portion of the screen display region of the display 301, and at least one among the audio module 314, the sensor module 304, the camera module 305, and the light-emitting element 306, aligned with the recesses or the openings, may be included. In another embodiment (not shown), the rear surface of the screen display region of the display 301 may include at least one among the audio module 314, the sensor module 304, the camera module 305, the fingerprint sensor 316, and light-emitting element 306. In another embodiment (not shown), the display 301 may be coupled to or disposed adjacent to a touch sensing circuit, a pressure sensor capable of measuring the intensity (pressure) of a touch, and/or a digitizer capable of detecting a magnetic stylus pen. In an embodiment, at least some of the sensor modules 304 and 519 and/or at least some of the key input devices 315 and 317 may be disposed in the first regions 310D and/or in the second regions 310E.

According to an embodiment, the audio modules 303, 307, and 314 may include a microphone hole 303 and speaker holes 307 and 314. In the microphone hole 303, a microphone may be disposed to acquire sound from the outside, and in an embodiment, multiple microphones may be disposed to detect the direction of sound. The speaker holes 307 and 314 may include an external speaker hole 307 and a receiver hole 314 for calls. In an embodiment, the speaker holes 307 and 314 and the microphone hole 303 may be implemented as a single hole, or may include a speaker without the speaker holes 307 and 314 (e.g., a piezo speaker).

According to an embodiment, the sensor modules 304, 316, and 319 may generate electrical signals or data values that correspond to the internal operational state of the electronic device 101 or an external environmental state. The sensor modules 304, 316, and 319 may include, for example, a first sensor module 304 (e.g., a proximity sensor) and/or a second sensor module (not shown) (e.g., a fingerprint sensor) disposed on the first surface 310A of the housing 310, and/or a third sensor module 319 (e.g., an HRM sensor) and/or a fourth sensor module 316 (e.g., a fingerprint sensor) disposed on the second surface 310B of the housing 310. The fingerprint sensor may be disposed not only on the first surface 310A (e.g., display 301) of the housing 310 but also on the second surface 310B thereof. The electronic device 101 may further include at least one of unillustrated sensor modules, such as a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, or an illuminance sensor 304.

According to an embodiment, the camera modules 305, 312, and 313 may include a first camera device 305 disposed on the first surface 310A of the electronic device 101, and a second camera device 312 and/or a flash 313 disposed on the second surface 310B of the electronic device 101. The camera modules 305 and 312 may include one or multiple lenses, an image sensor, and/or an image signal processor. The flash 313 may include, for example, a light-emitting diode or a xenon lamp. In an embodiment, two or more lenses (an infrared camera and a wide-angle and a telephoto lens) and image sensors may be disposed on one surface of the electronic device 101. According to an embodiment, at least one camera module 305 may be disposed in the bottom direction of the display 301. For example, the first camera device 305 may be disposed in at least a partial region of the display 301 corresponding to a camera's field of view (FOV). As the first camera device 305 is disposed in the at least a partial region of the display 301 corresponding to the camera's field of view (FOV), the position of the first camera device 305 may not be visually distinguishable (or exposed). According to an embodiment, when the display 301 is viewed from the first surface 310A, the first camera device 305 may be disposed in at least a portion of the display 301, which corresponds to the camera's field of view (FOV), to acquire an image of an external subject without being visually exposed to the outside. For example, the first camera device 305 may be an under-display camera (UDC).

According to an embodiment, the electronic device 101 may include multiple camera modules (e.g., dual cameras or triple cameras) each having different attributes (e.g., the field of view) or functions. For example, there may be multiple camera modules 305 and 312 that include lenses having different fields of view, and the electronic device 101 may control the field of view of the camera modules 305 and 312 operating in the electronic device 101 to be changed based on a user's selection. For example, at least one of the multiple camera modules 305 and 312 may be a wide-angle camera and at least another may be a telephoto camera. Similarly, at least one of the multiple camera modules 305 and 312 may be a front camera, and at least one of the multiple camera modules 305 and 312 may be a rear camera. Furthermore, the multiple camera modules 305 and 312 may include at least one of a wide-angle camera, a telephoto camera, or an infrared (IR) camera (e.g., a time-of-flight (TOF) camera or a structured light camera). According to an embodiment, an IR camera may operate as at least a portion of the sensor module. For example, the TOF camera may operate as at least portion of a sensor module (not shown) for detecting a distance to a subject.

According to an embodiment, the camera module 305 and/or the sensor modules may be disposed in the inner space of the electronic device 101 so as to be exposed to the external environment through the transparent region of the display 301 to the front plate 302. Additionally, some sensor modules (not shown) may be disposed to perform functions in the inner space of the electronic device without being visually exposed through the front plate 302.

According to an embodiment, the key input device 315 may be disposed on the first surface (or the front surface) 310A of the housing 310. According to an embodiment, the key input device 317 may be disposed on the side surface 310C of the housing 310. In another embodiment, the electronic device 101 may not include some or all of the above-mentioned key input devices 315 and 317, and the key input devices 315 and 317 that are not included may be implemented in other forms, such as soft keys, on the display 301. In an embodiment, the key input device 317 may include the sensor module 316 disposed on the second surface 310B of the housing 310.

According to an embodiment, the light-emitting element 306 may be disposed, for example, on the first surface 310A of the housing 310. The light-emitting element 306 may provide, for example, state information of the electronic device 101 in the form of light. In another embodiment, the light-emitting element 306 may provide, for example, a light source that operates in conjunction with the operation of the camera module 305. The light-emitting element 306 may include, for example, an LED, an IR LED, and a xenon lamp.

According to an embodiment, the connector holes 308 and 309 may include a first connector hole 308 that can accommodate a connector (e.g., a USB connector) for transmitting and receiving power and/or data to and from an external electronic device, and/or a second connector hole (e.g., an earphone jack) 309 that can accommodate a connector for transmitting and receiving audio signals to and from an external electronic device.

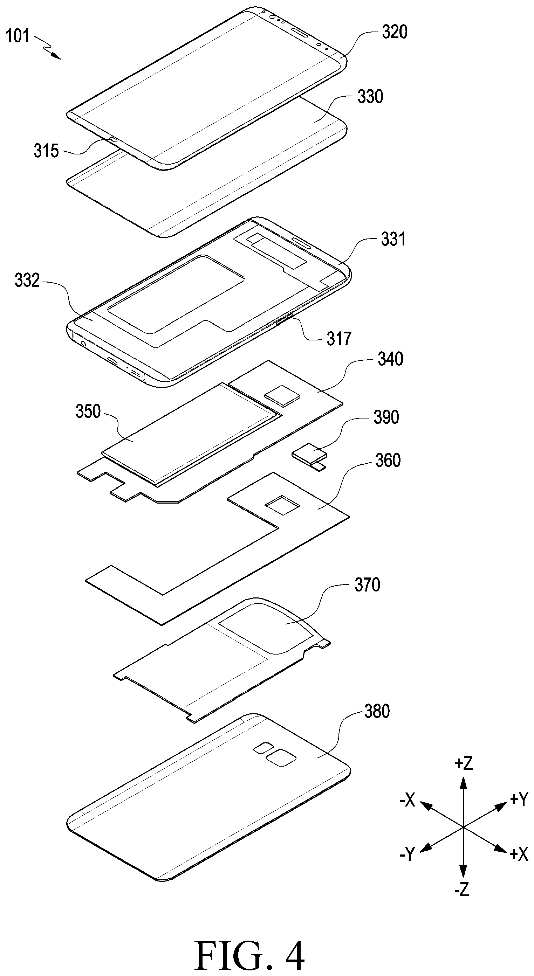

FIG. 4 is an exploded perspective view of an electronic device 101 according to an embodiment of the disclosure.

Referring to FIG. 4, the electronic device 101 (e.g., the electronic device 101 in FIGS. 1 to 4) may include a lateral bezel structure 331, a first support member 332 (e.g., a bracket), a front plate 320, a display 330, a printed circuit board 340, a battery 350, a second support member 360 (e.g., a rear case), an antenna 370, and a rear plate 380. **In** an embodiment, the electronic device 101 may omit at least one of the components (e.g., the first support member 332 or the second support member 360) or may additionally include other components. At least one of the components of the electronic device 101 may be the same as or similar to at least one of the components of the electronic device 101 in FIGS. 1 to 3, and redundant descriptions are omitted below.

According to an embodiment, the first support member 332 may be disposed in the electronic device 101 and connected to the lateral bezel structure 331, or may be integrally formed with the lateral bezel structure 331. The first support member 332 may be formed of, for example, a metal material and/or a non-metal (e.g., polymer) material. The first support member 332 may have one surface coupled to the display 330 and the other surface coupled to the printed circuit board 340. The printed circuit board 340 may be equipped with a processor, memory, and/or an interface. The processor may include one or more of, for example, a central processing unit, an application processor, a graphics processing unit, an image signal processor, a sensor hub processor, or a communications processor. According to an embodiment, the printed circuit board 340 may include a flexible printed circuit board type radio frequency cable (FRC). For example, the printed circuit board 340 may be disposed on at least a portion of the first support member 332 and may be electrically connected to an antenna module (e.g., the antenna module 197 in FIG. 1) and a communication module (e.g., the communication module 190 in FIG. 1).

According to an embodiment, the memory may include, for example, volatile memory or non-volatile memory.

According to an embodiment, the interface may include, for example, a high-definition multimedia interface (HDMI), a universal serial bus (USB) interface, an SD card interface, and/or an audio interface. The interface may electrically or physically connect the electronic device 101 to an external electronic device, for example, and may include a USB connector, an SD card/MMC connector, or an audio connector.

According to an embodiment, the battery 350 is a device for providing power to at least one component of the electronic device 101, and may include, for example, a non-rechargeable primary battery, a rechargeable secondary battery, or a fuel cell. At least a portion of the battery 350 may, for example, be disposed substantially coplanar with the printed circuit board 340. The battery 350 may be integrally disposed in the electronic device 101, or may be detachably disposed in the electronic device 101.

According to an embodiment, the second support member 360 (e.g., the rear case) may be disposed between the printed circuit board 340 and the antenna 370. For example, the second support member 360 may include one surface to which at least one of the printed circuit board 340 or the battery 350 is coupled, and the other surface to which the antenna 370 is coupled.

According to an embodiment, the antenna 370 may be disposed between the rear plate 380 and the battery 350. The antenna 370 may include, for example, a near-field communication (NFC) antenna, a wireless charging antenna, and/or a magnetic secure transmission (MST) antenna. The antenna 370 may, for example, perform short-range communication with an external device or wirelessly transmit and receive power required for charging. In another embodiment, the antenna structure may be formed by a portion of or a combination of the lateral bezel structure 331 and/or the first support member 332.

According to various embodiments of the disclosure, the electronic device 101 may include multiple antenna modules 390. For example, some of the multiple antenna modules 390 may be implemented to transmit and receive radio waves having different characteristics (referred to as radio waves in A and B frequency bands) for MIMO implementation. In another example, some of the multiple antenna modules 390 may be configured to simultaneously transmit and receive radio waves having the same characteristics (referred to as radio waves of frequencies A1 and A2 in frequency band A), for example, to implement diversity. In another example, others of the multiple antenna modules 390 may be configured to simultaneously transmit and receive radio waves having the same characteristics (referred to as radio waves of frequencies B1 and B2 in frequency band B), for example, to implement diversity. In an embodiment of the disclosure, the electronic device 101 may include two antenna modules, but in another embodiment of the disclosure, the electronic device 101 may include four antenna modules to implement both MIMO and diversity. In another embodiment, the electronic device 101 may include only one antenna module 390.

According to an embodiment, in consideration of the transmission and reception characteristics of radio waves, when one antenna module is disposed at a first position on the printed circuit board 340, another antenna module may be disposed at a second position separated from the first position on the printed circuit board 340. In another example, the one antenna module and the other antenna module may be disposed in consideration of a mutual separation distance based on diversity characteristics.

According to an embodiment, at least one antenna module 390 may include a wireless communication circuit for processing radio waves transmitted or received in an ultra-high frequency band (e.g., 6 GHz or higher and 300 GHz or lower). A conductive plate of the at least one antenna module 390 may be formed as, for example, a patch-type radiation conductor or a conductive plate having a dipole structure extending in one direction, and multiple conductive plates may be arrayed to form an antenna array. A chip (e.g., an integrated circuit chip) or the like on which a portion of the wireless communication circuit is implemented may be disposed on one side of a region in which the conductive plate is disposed or on a surface facing in an opposite direction to a surface on which the conductive plate is disposed, and may be electrically connected to the conductive plate via wiring formed as a printed circuit pattern.

The electronic device 101 disclosed herein has a bar-type or plate-type appearance, but the disclosure is not limited thereto. For example, the illustrated electronic device 101 may be a rollable electronic device or a foldable electronic device. Depending on a user's needs, the rollable electronic device or the foldable electronic device may be used to expand a screen display region by unfolding the display or by exposing a larger area of the display to the outside. In an embodiment, the electronic device 101 according to various embodiments disclosed herein may be interpreted as including not only portable electronic devices such as smartphones, but also various other electronic devices such as laptop computers or cameras.

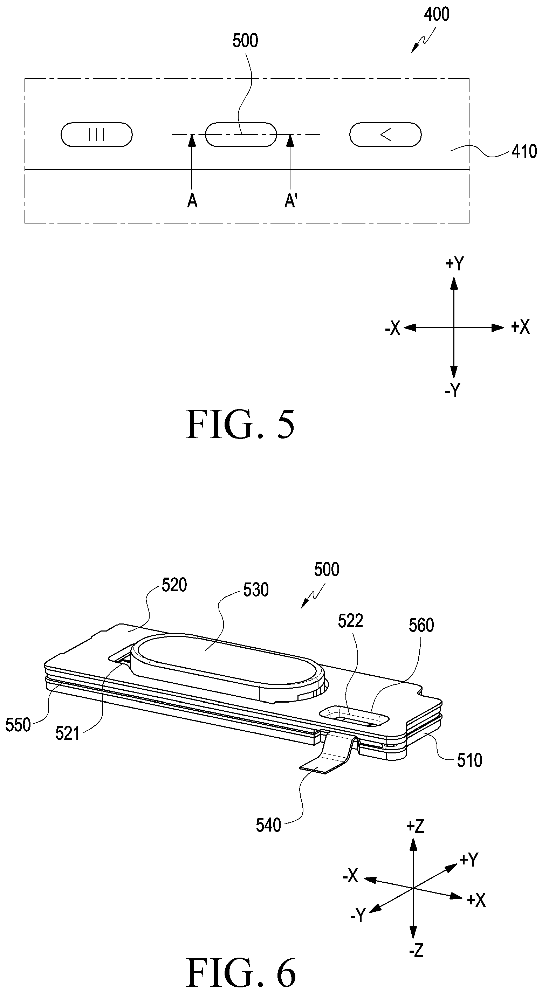

FIG. 5 illustrates one surface of an electronic device 400 having a key assembly 500 disposed therein according to various embodiments of the disclosure. FIG. 6 is a perspective view of the key assembly 500 according to an embodiment of the disclosure.

Referring to FIGS. 5 and 6, the electronic device 400 may include a housing 410 and a key assembly 500. The key assembly 500 may include a first plate 510, a second plate 520, a key 530, a printed circuit board 540, a sealing member 550, and a bonding member 560. The configuration of the housing 410 and the key assembly 500 in FIGS. 5 and 6 may be partially or entirely the same as the configuration of the housing 310 and the key input devices 315 and 317 in FIGS. 2 and 3.

In FIGS. 5 and 6, it may be defined and interpreted that "X" is the width direction of the electronic device 400, "Y" is the length direction of the electronic device 400, and "Z" is the thickness direction of the electronic device 400. In an embodiment of the disclosure, "X" may refer to a (1-1)th direction (the +X direction) and a (1-2)th direction (the -X direction). In an embodiment of the disclosure, "Y" may refer to a (2-1)th direction (the +Y direction) and a (2-2)th direction (the-Y direction). In an embodiment of the disclosure, "Z" may refer to a (3-1)th direction (the +Z direction) and a (3-2)th direction (the -Z direction).

According to an embodiment, the key assembly 500 may be formed such that at least a portion thereof is exposed through an opening formed in the housing 410. According to an embodiment, the key entry device 315 may be disposed on the first surface (or the front surface) 310A of the housing 310. According to another embodiment (not shown), the key input device 317 may be disposed on the side surface 310C of the housing 310.

According to a typical electronic device, the waterproof structure of the key assembly 500 may rely solely on the adhesion between waterproof tapes. The printed circuit board 540 and the waterproof tape may overlap, causing excessive stress between the first plate 510 and the second plate 520 of the key assembly 500. When a user presses the key 530 of the key assembly 500, the printed circuit board 540 disposed inside the key assembly 500 may also be pressed, thereby causing the waterproof structure of the printed circuit board 540 to be broken or weakened. The waterproof tapes may exhibit weak adhesion due to insufficient adhesive areas, thereby causing a gap to form between the waterproof tapes of the key assembly 500. To prevent these, a complex process may be required, resulting in a long manufacturing time.

According to an embodiment of the disclosure, the bonding member 560 may be applied to the printed circuit board 540 in the key assembly 500 to fix the position of the printed circuit board 540 and improve the waterproof quality. The structure of the key assembly 500 will be described in detail below.

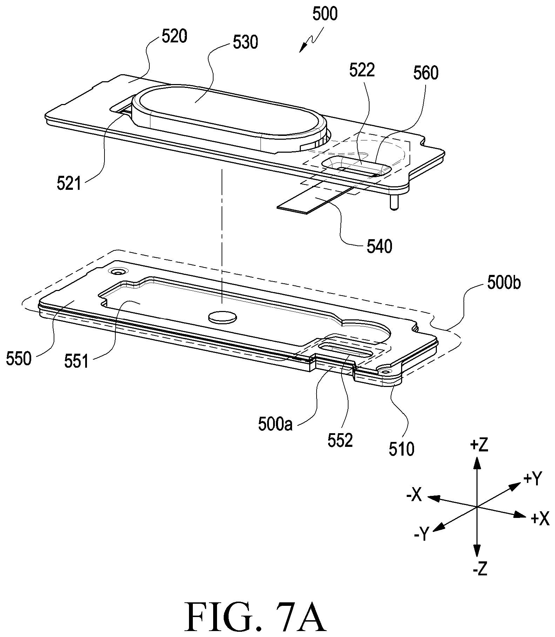

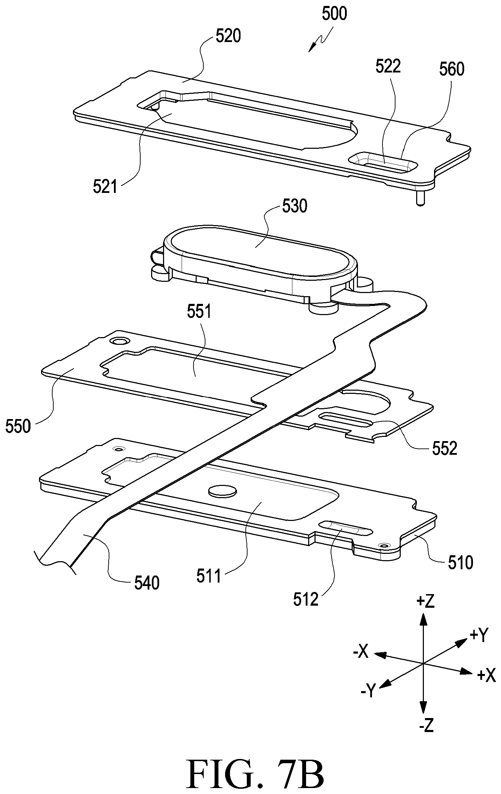

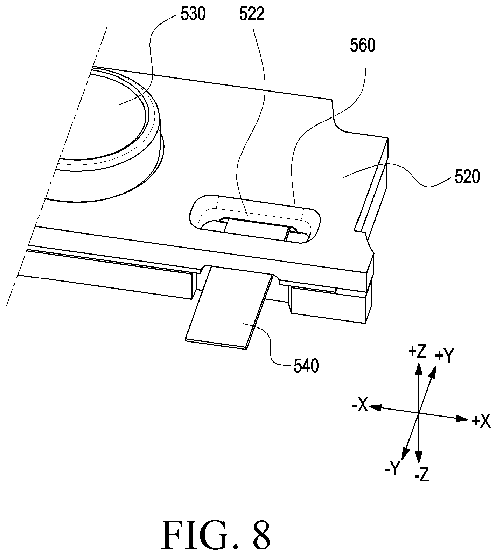

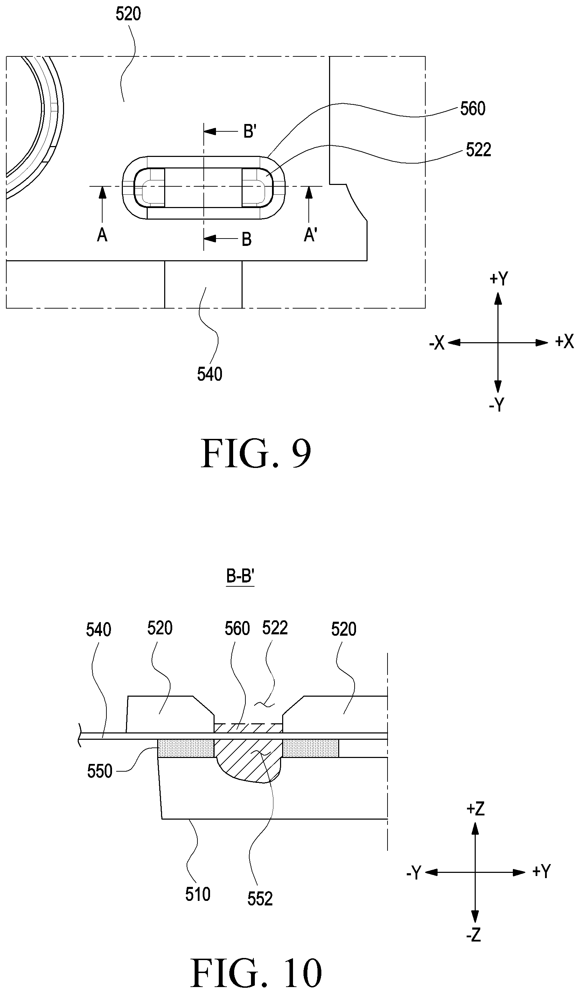

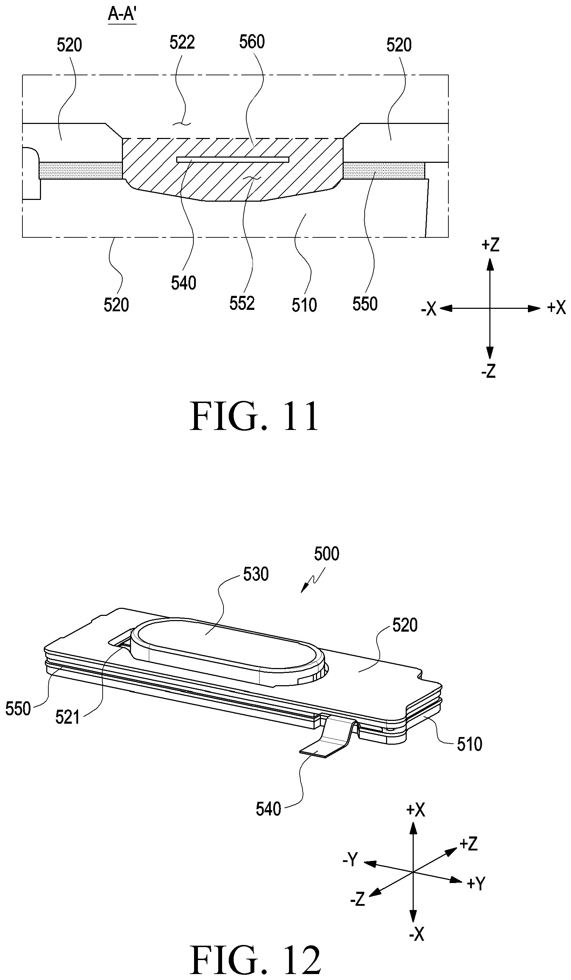

FIGS. 7A and 7B are exploded perspective views of a key assembly 500 according to an embodiment of the disclosure. FIG. 8 is a perspective view of a withdrawal portion of a printed circuit board 540, as seen from the top surface, according to an embodiment of the disclosure. FIG. 9 is a front view of the withdrawal portion of the printed circuit board 540, as seen from above, according to an embodiment of the disclosure. FIG. 10 is a cross-sectional view of the withdrawal portion of the printed circuit board 540 in FIG. 9, taken along line B-B', according to an embodiment of the disclosure. FIG. 11 is a cross-sectional view of the withdrawal portion of the printed circuit board 540 in FIG. 9, taken along line A-A', according to an embodiment of the disclosure.

Referring to FIGS. 7A to 11, the electronic device 400 may include a housing 410 and a key assembly 500. The key assembly 500 may include a first plate 510, a second plate 520, a key 530, a printed circuit board 540, a sealing member 550, and a bonding member 560. The configuration of the housing 410 and the key assembly 500 in FIGS. 7A to 11 may be partially or entirely the same as the configuration of the housing 410 and the key assembly 500 in FIG. 5.

In FIGS. 7A to 11, it may be defined and interpreted that "X" is the width direction of the electronic device 400, "Y" is the length direction of the electronic device 400, and "Z" is the thickness direction of the electronic device 400. In an embodiment of the disclosure, "X" may refer to a (1-1)th direction (the +X direction) and a (1-2)th direction (-X direction). In an embodiment of the disclosure, "Y" may refer to a (2-1)th direction (the +Y direction) and a (2-2)th direction (the -Y direction). In an embodiment of the disclosure, "Z" may refer to a (3-1)th direction (the +Z direction) and a (3-2)th direction (the -Z direction).

According to an embodiment, referring to FIG. 7A, the key assembly 500 may be divided into a first region 500a, which includes a withdrawal region through which the printed circuit board 540 disposed in the key assembly 500 and electrically connected to the key 530 is withdrawn to the outside of the key assembly 500, and a second region 500b, which is the remaining region excluding the first region 500A. The first region 500a and the second region 500b may have different waterproof structures. This will be described below.

According to an embodiment, plates (e.g., glass plates including various coating layers, or polymer plates) of the key assembly 500 may include a first plate 510 and a second plate 520 disposed on the first plate 510. The plates of the key assembly 500 may be formed of, for example, coated or tinted glass, ceramic, polymer, metal (e.g., aluminum, stainless steel (STS), or magnesium), or a combination of at least two of the above materials.

According to an embodiment, either the first plate 510 or the second plate 520 may include a first hole 521 formed at a position corresponding to an opening. For example, the second plate 520 may include the first hole 521 formed at a position corresponding to the opening. The first hole 521 may be positioned in the second region 500b of the key assembly 500. The first hole 521 may correspond to the shape of the opening formed in the housing. The first hole 521 may correspond to one surface of the key 530 which faces the +Z direction and is at least partially exposed through the opening formed in the housing.

According to an embodiment, either the first plate 510 or the second plate 520 may include a second hole 522 formed at a position corresponding to the printed circuit board 540. For example, the second plate 520 may include the second hole 522 formed at a position corresponding to the printed circuit board 540. The second hole 522 may be spaced apart from the first hole 521. The second hole 522 may be positioned in the first region 500a of the key assembly 500. For example, the second hole 522 may include a withdrawal region through which the printed circuit board 540 is withdrawn to the outside. For example, the first plate 510 may include the first hole 521 formed in a position corresponding to the opening, and the second hole 522 formed in a position corresponding to a withdrawal region of the printed circuit board 540. For example, the second plate 520 may include the first hole 521 formed in a position corresponding to the opening, and the second hole 522 formed in a position corresponding to the withdrawal region of the printed circuit board 540, which will be described later.

According to an embodiment, the first plate 510 may further include a first recess 511 formed in the first region 500a and a second recess 512 formed in the second region 500b.

According to an embodiment, at least a portion of the key 530 may be disposed between the first plate 510 and the second plate 520. At least a portion of the key 530 may be exposed to the outside of the electronic device by passing through the first hole 521.

According to an embodiment, the printed circuit board 540 electrically connected to the key 530 may be disposed between the first plate 510 and the second plate 520. According to an embodiment, the printed circuit board 540 may include a flexible printed circuit board type radio frequency cable (FRC). The printed circuit board 540 may be disposed on the same plane (e.g., an XY plane) as the key 530. The printed circuit board 540 may have one side in contact with the key 530 and the other side withdrawn to the outside of the key assembly 500. A withdrawal region through which the printed circuit board 540 is withdrawn to the outside of the key assembly 500 may be defined as the first region 500a of the key assembly 500. At least a portion of the printed circuit board 540 may be positioned in the first region 500a.

According to an embodiment, the sealing member 550 may be disposed between the plate and the printed circuit board 540. The sealing member 550 may be disposed between the plate in which the second hole 522 is formed and the printed circuit board 540. For example, the sealing member 550 may be disposed between the first plate 510 in which the second hole 522 is formed and the printed circuit board 540. The sealing member 550 may be an adhesive member, for example, a double-sided tape (e.g., a PET double-sided tape).

According to an embodiment, the sealing member 550 may include one or more holes. The sealing member 550 may be disposed along the edge of the plate and may include a third hole 551 at least partially corresponding to the first hole 521. The sealing member 550 may include a fourth hole 552 corresponding to the second hole 522. The sealing member 550 may include the third hole 551 and the fourth hole 552. The key 530 may extend through the third hole 551 of the sealing member 550. The fourth hole 552 may be coated with the bonding member 560, which will be described later.

According to an embodiment, the bonding member 560 may be applied to the first region 500a of the key assembly 500. For example, the bonding member 560 may be applied inside the second hole 522 formed in the second plate 520 and may be configured to bond a portion of the printed circuit board 540 to the second plate 520. The bonding member 560 may be formed to surround the printed circuit board 540. The bonding member 560 may coat an inner space surrounded by the second hole 522 formed in the second plate 520, the fourth hole 552 formed in the sealing member 550, and the second recess 512 formed in the first plate 510. The printed circuit board 540 may be fixed to the first region 500a of the key assembly 500 by the bonding member 560.

According to an embodiment, in the first region 500a of the key assembly 500, moisture may not be transmitted to the edge of the key assembly 500 by the sealing member 550. According to an embodiment, the first region 500a of the key assembly 500 may be configured to include the bonding member 560. According to an embodiment, an ultrasonic welding structure may be applied to the first region 500a of the key assembly 500.

According to an embodiment, the bonding member 560 may be formed to surround the printed circuit board 540. According to an embodiment, in the first region 500a of the key assembly 500, with respect to the printed circuit board 540, one surface of the printed circuit board 540, facing the (3-1)th direction (the +Z direction), may be waterproofed by the bonding member 560, while one surface of the printed circuit board 540, facing the (3-2)th direction (the -Z direction), may be waterproofed by the sealing member 550. When at least one surface is in contact with the bonding member 560, stress caused by a position change that occurs when the user presses the key 530 may not be transmitted to the bonding member 560. Bending stress in the printed circuit board 540 that is withdrawn to the outside of the key assembly 500 may not be transmitted to the bonding member 560.

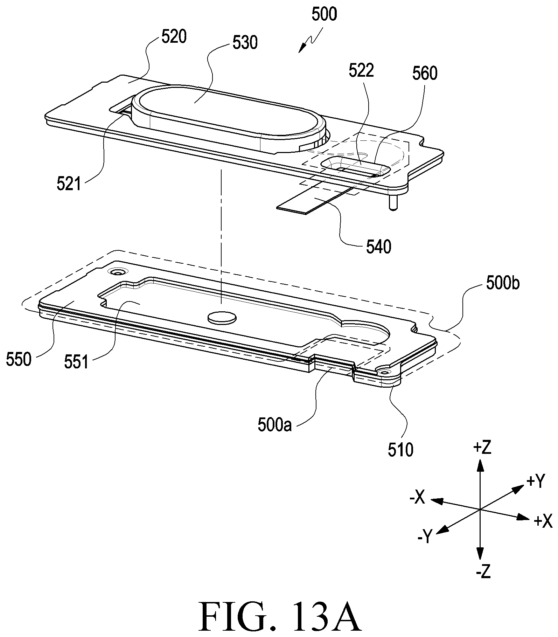

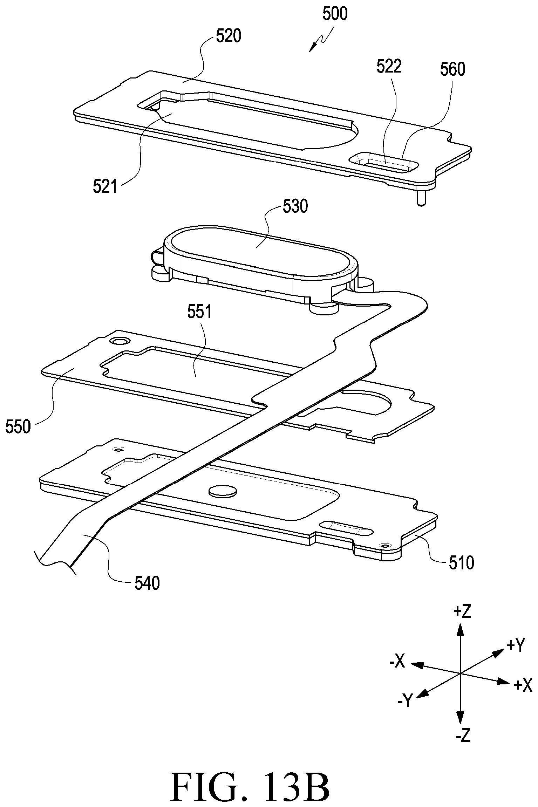

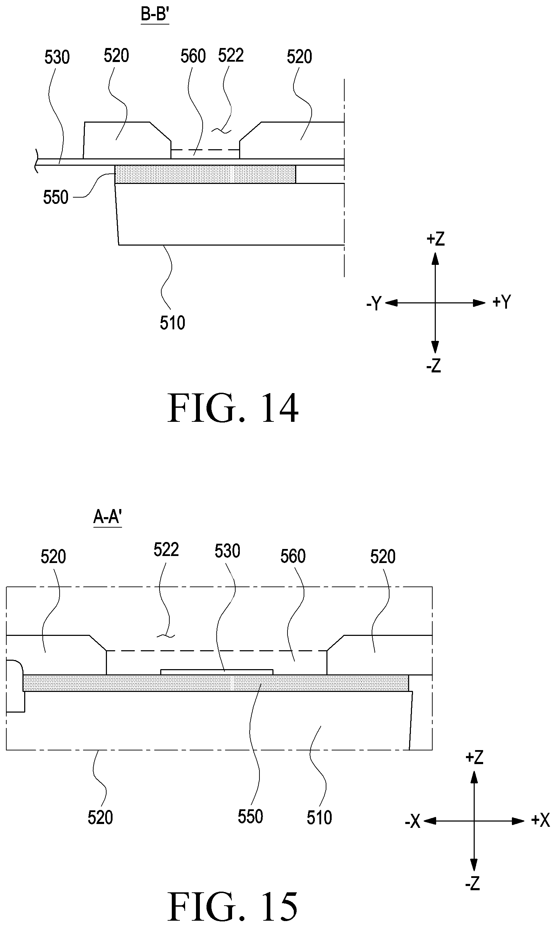

FIG. 12 is a perspective view of a key assembly 500 according an embodiment of the disclosure. FIGS. 13A and 13B are exploded perspective views of the key assembly 500 according to an embodiment of the disclosure. FIG. 14 is a cross-sectional view of the withdrawal portion of the printed circuit board 540 in FIG. 9, taken along line B-B'. FIG. 15 is a cross-sectional view of the withdrawal portion of the printed circuit board in FIG. 9, taken along line A-A'.

Referring to FIGS. 12 to 15, an electronic device 400 may include a housing 410 and a key assembly 500. The key assembly 500 may include a first plate 510, a second plate 520, a key 530, a printed circuit board 540, a sealing member 550, and a bonding member 560. The configuration of the housing 410 and the key assembly 500 in FIGS. 12 to 15 may be partially or entirely the same as the configuration of the housing 410 and the key assembly 500 in FIGS. 6 to 11.

In FIGS. 12 to 15, it may be defined and interpreted that "X" is the width direction of the electronic device 400, "Y" is the length direction of the electronic device 400, and "Z" is the thickness direction of the electronic device 400. In an embodiment of the disclosure, "X" may refer to a (1-1)th direction (the +X direction) and a (1-2)th direction (-X direction). In an embodiment of the disclosure, "Y" may refer to a (2-1)th direction (the +Y direction) and a (2-2)th direction (the -Y direction). In an embodiment of the disclosure, "Z" may refer to a (3-1)th direction (the +Z direction) and a (3-2)th direction (the -Z direction).

According to an embodiment, the key assembly 500 may be divided into a first region 500a, which includes a withdrawal region through which the printed circuit board 540 disposed in the key assembly 500 and electrically connected to the key 530 is withdrawn to the outside of the key assembly 500, and a second region 500b, which is the remaining region excluding the first region 500A. The first region 500a and the second region 500b may have different waterproof structures. This will be described below.

According to an embodiment, plates (e.g., glass plates including various coating layers, or polymer plates) of the key assembly 500 may include a first plate 510 and a second plate 520 disposed on the first plate 510. The plates of the key assembly 500 may be formed of, for example, coated or tinted glass, ceramic, polymer, metal (e.g., aluminum, stainless steel (STS), or magnesium), or a combination of at least two of the above materials.

According to an embodiment, either the first plate 510 or the second plate 520 may include a first hole 521 formed at a position corresponding to an opening. For example, the second plate 520 may include the first hole 521 formed at a position corresponding to the opening. The first hole 521 may be positioned in the second region 500b of the key assembly 500. The first hole 521 may correspond to the shape of the opening formed in the housing. The first hole 521 may correspond to one surface of the key 530 which faces the +X direction and is at least partially exposed through the opening formed in the housing.

According to an embodiment, either the first plate 510 or the second plate 520 may include a second hole 522 formed at a position corresponding to the printed circuit board 540. For example, the second plate 520 may include the second hole 522 formed at a position corresponding to the printed circuit board 540. The second hole 522 may be spaced apart from the first hole 521. The second hole 522 may be positioned in the first region 500a of the key assembly 500. For example, the second hole 522 may include a withdrawal region through which the printed circuit board 540 is withdrawn to the outside. For example, the first plate 510 may include the first hole 521 formed in a position corresponding to the opening, and the second hole 522 formed in a position corresponding to the withdrawal region of the printed circuit board 540. For example, the second plate 520 may include the first hole 521 formed in a position corresponding to the opening, and the second hole 522 formed in a position corresponding to the withdrawal region of the printed circuit board 540, which will be described later.

According to an embodiment, the first plate 510 may further include a first recess 511 formed in the first region 500a and a second recess 512 formed in the second region 500b.

According to an embodiment, at least a portion of the key 530 may be disposed between the first plate 510 and the second plate 520. At least a portion of the key 530 may be exposed to the outside of the electronic device by passing through the first hole 521.

According to an embodiment, the printed circuit board 540 electrically connected to the key 530 may be disposed between the first plate 510 and the second plate 520. According to an embodiment, the printed circuit board 540 may include a flexible printed circuit board type radio frequency cable (FRC). The printed circuit board 540 may be disposed on the same plane (e.g., an XY plane) as the key 530. The printed circuit board 540 may have one side in contact with the key 530 and the other side withdrawn to the outside of the key assembly 500. A withdrawal region through which the printed circuit board 540 is withdrawn to the outside of the key assembly 500 may be defined as the first region 500a of the key assembly 500. At least a portion of the printed circuit board 540 may be positioned in the first region 500a.

According to an embodiment, the sealing member 550 may be disposed between the plate and the printed circuit board 540. The sealing member 550 may be disposed between the plate in which the second hole 522 is formed and the printed circuit board 540. For example, the sealing member 550 may be disposed between the first plate 510 in which the second hole 522 is formed and the printed circuit board 540. The sealing member 550 may be an adhesive member, for example, a double-sided tape (e.g., a PET double-sided tape).

According to an embodiment, the sealing member 550 may include one or more holes. The sealing member 550 may be disposed along the edge of the plate and may include a third hole 551 at least partially corresponding to the first hole 521. The key 530 may pass through the third hole 551 of the sealing member 550. According to an embodiment, unlike FIG. 7A, the first region 500A may not include a hole corresponding to the second hole 522.

According to an embodiment, the bonding member 560 may be applied to the first region 500a of the key assembly 500. For example, the bonding member 560 may be applied inside the second hole 522 formed in the second plate 520 and may be configured to bond a portion of the printed circuit board 540 to the second plate 520. The bonding member 560 may be formed to surround the printed circuit board 540. The bonding member 560 may coat an inner space surrounded by the second hole 522 formed in the second plate 520 and the sealing member 550. The printed circuit board 540 may be fixed to the first region 500a of the key assembly 500 by the bonding member 560.

According to an embodiment, in the first region 500a of the key assembly 500, moisture may not be transmitted to the edge of the key assembly 500 by the sealing member 550. According to an embodiment, the first region 500a of the key assembly 500 may be configured to include the bonding member 560. According to an embodiment, an ultrasonic welding structure may be applied to the first region 500a of the key assembly 500.

According to an embodiment, the bonding member 560 may be formed to surround the printed circuit board 540. According to an embodiment, in the first region 500a of the key assembly 500, with respect to the printed circuit board 540, one surface of the printed circuit board 540, facing the (3-1)th direction (the +Z direction), may be waterproofed by the bonding member 560, while one surface of the printed circuit board 540, facing the (3-2)th direction (the -Z direction), may be waterproofed by the sealing member 550. When at least one surface is in contact with the bonding member 560, stress caused by a position change that occurs when the user presses the key 530 may not be transmitted to the bonding member 560. Bending stress in the printed circuit board 540 that is withdrawn to the outside of the key assembly 500 may not be transmitted to the bonding member 560.

Structurally, the area of the display screen of the electronic device may increase relative to the area of the housing. As the area of the display screen increases, the mounting space for the key assembly 500 may be reduced, and the area of the applicable sealing member 550 may also decrease, thereby causing poor waterproofing.

According to a typical electronic device, the waterproof structure of the key assembly 500 may rely solely on the adhesion between waterproof tapes. The printed circuit board 540 and the waterproof tape may overlap, causing excessive stress between the first plate 510 and the second plate 520 of the key assembly 500. When a user presses the key 530 of the key assembly 500, the printed circuit board 540 disposed inside the key assembly 500 may also be pressed, thereby damaging or weaken the waterproof structure of the printed circuit board 540. The waterproof tapes may exhibit weak adhesion due to insufficient adhesive areas, thereby causing a gap to form between the waterproof tapes of the key assembly 500. To prevent these, a complex process may be required, resulting in a long manufacturing time.

According to an embodiment of the disclosure, the bonding member 560 may be applied to the printed circuit board 540 inside the key assembly 500 to fix the position of the printed circuit board 540 and enhance waterproof quality.

## Claims

1. An electronic device comprising:
a housing (410) comprising an opening formed on one surface; and
a key assembly (500) formed to be at least partially exposed through the opening,
wherein the key assembly comprises:
a first plate (510);
a second plate (520) disposed on the first plate and comprising a first hole (521) formed at a position corresponding to the opening and a second hole (522) spaced apart from the first hole,
a key (530), at least a portion of which passes through the first hole,
a printed circuit board (540), one end of which is connected to the key and at least a portion of which is disposed at a position corresponding to the second hole,
a sealing member (550) disposed between the first plate and the second plate along an edge of the key assembly, and comprising a third hole (551) corresponding to the first hole, and
a bonding member (560) applied inside the second hole to bond the portion of the printed circuit board to the second plate.

2. The electronic device of claim 1, wherein the key assembly is divided into a first region (500a) comprising a region through which the printed circuit board is withdrawn outward from the key assembly, and a second region (500b) excluding the first region.

3. The electronic device of claim 2, wherein unlike the first region (500a), the second region (500b) comprises the bonding member (560).

4. The electronic device of claim 2,
wherein the first hole (521) is disposed in the second region, and
wherein the second hole (522) is disposed in the first region.

5. The electronic device of claim 2, wherein the first plate (510) further comprises a recess (512) that is recessed downward in the second region.

6. The electronic device of one of the preceding claims, wherein the printed circuit board (540) is disposed between the second plate (520) and the sealing member (550).

7. The electronic device of one of the preceding claims,
wherein a fingerprint sensor is disposed on one surface of the key (530), and
wherein the fingerprint sensor is electrically connected to the printed circuit board (540).

8. The electronic device of one of the above-described claims, wherein the sealing member (550) comprises a double-sided tape.

9. The electronic device of claim 5, wherein the sealing member further comprises a fourth hole (552) corresponding to the second hole.

10. The electronic device of claim 9, wherein the bonding member (560) is applied to an inner space formed by the second hole (522), the fourth hole (552), and the recess (512).

## Patentansprüche

1. Elektronische Vorrichtung, umfassend:
ein Gehäuse (410), das eine auf einer Fläche ausgebildete Öffnung umfasst; und
eine Schlüsselanordnung (500), die so ausgebildet ist, dass sie zumindest teilweise durch die Öffnung freiliegt,
wobei die Schlüsselanordnung umfasst:
eine erste Platte (510);
eine zweite Platte (520), die auf der ersten Platte angeordnet ist und ein erstes Loch (521), das an einer der Öffnung entsprechenden Position ausgebildet ist, und ein zweites Loch (522) umfasst, das von dem ersten Loch beabstandet ist,
einen Schlüssel (530), von dem mindestens ein Abschnitt durch das erste Loch geht,
eine Leiterplatte (540), deren eines Ende mit dem Schlüssel verbunden ist und von der mindestens ein Abschnitt an einer dem zweiten Loch entsprechenden Position angeordnet ist,
ein Dichtungselement (550), das zwischen der ersten Platte und der zweiten Platte entlang eines Randes der Schlüsselanordnung angeordnet ist und ein drittes Loch (551) umfasst, das dem ersten Loch entspricht, und
ein Verbindungselement (560), das innerhalb des zweiten Lochs angebracht ist, um den Abschnitt der Leiterplatte mit der zweiten Platte zu verbinden.

2. Elektronische Vorrichtung nach Anspruch 1, wobei die Schlüsselanordnung in einen ersten Bereich (500a), der einen Bereich umfasst, durch den die Leiterplatte aus der Schlüsselanordnung herausgezogen wird, und einen zweiten Bereich (500b) unterteilt ist, der den ersten Bereich ausschließt.

3. Elektronische Vorrichtung nach Anspruch 2, wobei im Gegensatz zum ersten Bereich (500a) der zweite Bereich (500b) das Verbindungselement (560) umfasst.

4. Elektronische Vorrichtung nach Anspruch 2,
wobei das erste Loch (521) im zweiten Bereich angeordnet ist, und
wobei das zweite Loch (522) im ersten Bereich angeordnet ist.

5. Elektronische Vorrichtung nach Anspruch 2, wobei die erste Platte (510) ferner eine Ausnehmung (512) umfasst, die im zweiten Bereich nach unten ausgespart ist.

6. Elektronische Vorrichtung nach einem der vorhergehenden Ansprüche, wobei die Leiterplatte (540) zwischen der zweiten Platte (520) und dem Dichtungselement (550) angeordnet ist.

7. Elektronische Vorrichtung nach einem der vorhergehenden Ansprüche,
wobei ein Fingerabdrucksensor auf einer Fläche des Schlüssels (530) angeordnet ist, und
wobei der Fingerabdrucksensor elektrisch mit der Leiterplatte (540) verbunden ist.

8. Elektronische Vorrichtung nach einem der oben beschriebenen Ansprüche, wobei das Dichtungselement (550) ein doppelseitiges Band umfasst.

9. Elektronische Vorrichtung nach Anspruch 5, wobei das Dichtungselement ferner ein viertes Loch (552) umfasst, das dem zweiten Loch entspricht.

10. Elektronische Vorrichtung nach Anspruch 9, wobei das Verbindungselement (560) an einem Innenraum angebracht ist, der durch das zweite Loch (522), das vierte Loch (552) und die Ausnehmung (512) ausgebildet ist.

## Revendications

1. Dipspositif électronique, comprenant :
un boîtier (410) comprenant une ouverture formée sur une surface ; et
un ensemble de clés (500) formé pour être au moins partiellement exposé à travers l'ouverture,
dans lequel l'ensemble de clés comprend :
une première plaque (510) ;
une seconde plaque (520) disposée sur la première plaque et comprenant un premier trou (521) formé à une position correspondant à l'ouverture et un second trou (522) espacé du premier trou,
une clé (530) dont au moins une partie passe à travers le premier trou,
une carte de circuit imprimé (540) dont une extrémité est connectée à la clé et dont au moins une partie est disposée à une position correspondant au second trou,
un élément d'étanchéité (550) disposé entre la première plaque et la seconde plaque le long d'un bord de l'ensemble de clés, et comprenant un troisième trou (551) correspondant au premier trou, et
un élément de liaison (560) appliqué à l'intérieur du second trou pour lier la partie de la carte de circuit imprimé à la seconde plaque.

2. Dispositif électronique de la revendication 1, dans lequel l'ensemble de clés est divisé en une première région (500a) comprenant une région à travers laquelle la carte de circuit imprimé est retirée vers l'extérieur de l'ensemble de clés, et une seconde région (500b) excluant la première région.

3. Dispositif électronique de la revendication 2, dans lequel contrairement à la première région (500a), la seconde région (500b) comprend l'élément de liaison (560).

4. Dispositif électronique de la revendication 2,
dans lequel le premier trou (521) est situé dans la seconde région, et
dans lequel le second trou (522) est situé dans la première région.

5. Dispositif électronique de la revendication 2, dans lequel la première plaque (510) comprend en outre un évidement (512) qui est évidé vers le bas dans la seconde région.

6. Dispositif électronique de l'une des revendications précédentes, dans lequel la carte de circuit imprimé (540) est disposée entre la seconde plaque (520) et l'élément d'étanchéité (550).

7. Dispositif électronique de l'une des revendications précédentes,
dans lequel un capteur d'empreintes digitales est disposé sur une surface de la clé (530), et
dans lequel le capteur d'empreintes digitales est relié électriquement à la carte de circuit imprimé (540).

8. Dispositif électronique de l'une des revendications décrites ci-dessus, dans lequel l'élément d'étanchéité (550) comprend un ruban adhésif double face.

9. Dispositif électronique de la revendication 5, dans lequel l'élément d'étanchéité comprend en outre un quatrième trou (552) correspondant au second trou.

10. Dispositif électronique de la revendication 9, dans lequel l'élément de liaison (560) est appliqué sur un espace intérieur formé par le second trou (522), le quatrième trou (552) et l'évidement (512).
